## Europäisches Patentamt

## European Patent Office

(11) Numéro de publication: **0 142 439**
**B1**

## Office européen des brevets

(12)

# FASCICULE DE BREVET EUROPÉEN

(45) Date de publication du fascicule du brevet:
20.07.88

(51) Int. Cl.⁴: **G 06 F  5/00,** H 03 M  3/04,
H 04 N  7/13

(21) Numéro de dépôt: **84402265.7**

(22) Date de dépôt: **09.11.84**

(54) **Procédé de compression d'une succession d'informations numériques, et dispositif mettant en oeuvre ce procédé.**

(30) Priorité: **15.11.83  FR 8318132**

(43) Date de publication de la demande:
**22.05.85 Bulletin 85/21**

(45) Mention de la délivrance du brevet:
**20.07.88 Bulletin 88/29**

(84) Etats contractants désignés:
**DE IT NL**

(56) Documents cité:
**DE-A-2 405 534**
**FR-A-2 314 618**
**US-A-3 560 639**
**US-A-3 723 879**

**NACHRICHTENTECHNISCHE ZEITSCHRIFT, vol. 27, no. 3, mars 1974, pages 115-117, Berlin, DE; G. BOSTELMANN: "A simple high quality DPCM-codec for video telephony using 8 Mbit per second"**

(73) Titulaire: **THOMSON- CGR, 13, square Max-Hymans, F-75015 Paris (FR)**

(72) Inventeur: **Lienard, Jean, THOMSON- CSF SCPI 173, bld Haussmann, F-75379 Paris Cedex 08 (FR)**
Inventeur: **Denoize, Xavier, THOMSON- CSF SCPI 173, bld Haussmann, F-75379 Paris Cedex 08 (FR)**
Inventeur: **Dessales- Martin, Diane, THOMSON-CSF SCPI 173, bld Haussmann, F-75379 Paris Cedex 08 (FR)**

(74) Mandataire: **Barbin le Bourhis, Joel, THOMSON-CSF SCPI 173, boulevard Haussmann, F-75379 Paris Cedex 08 (FR)**

## Description

L'invention concerne un procédé de compression d'une succession d'informations numériques binaires, notamment représentatives des pixels d'une image numérisée ; l'invention a aussi pour objet un dispositif mettant en oeuvre un tel procédé.

Dans un système numérique d'acquisition d'images, les valeurs des différentes zones élémentaires de l'image ou pixels sont transcrites en mots. La valeur de chaque mot représente la "luminance" du pixel considéré. Par exemple, dans le domaine de la radiologie numérique, l'image radiologique est visualisée par un amplificateur de luminance, captée par une caméra et le signal de cette caméra est échantillonné. La suite d'échantillons ainsi élaborée représente par exemple une lecture ligne par ligne par "balayage" des différents pixels de ces lignes. Cette suite d'échantillons est numérisée, c'est-à-dire transformée en une suite de mots. Si par exemple, chaque mot est codé sur 8 bits, ce qui représente une gradation de 0 à 255 du noir au blanc et si on se définit une image de 512 X 512 pixels, la capacité mémoire est importante, soit 2 097 152 bits à mémoriser. Lorsque de nombreuses images doivent être mémorisées, une mémoire de masse est indispensable. On utilise souvent un stockage sur disque magnétique. Généralement, une mémoire tampon de capacité limitée est couplée à la mémoire de masse, pour le transfert des informations. La mémoire de masse est donc "alimentée" par lectures successives des informations contenues dans la mémoire tampon. Les contraintes technologiques actuelles font que te transfert du contenu de la mémoire tampon vers la mémoire de masse est une opération qui demande du temps et qui limite les performances du système à un rythme d'images insuffisant dans certains cas, par exemple si on veut observer des phénomènes rapides comme l'évolution d'un produit de contraste dans le système sanguin ou le coeur. Il y a donc intérêt à comprimer les informations représentatives d'une image en exploitant les redondances spatiales et/ou temporelles inhérentes à celle-ci. Le taux de compression définit le gain réalisé après traitement. Ainsi, un taux de compression de 2 signifie qu'une mémoire tampon ayant la capacité nécessaire pour mémoriser une image normale complète, peut aussi accueillir les informations représentatives de deux images, après compression. Comme le temps de transfert entre la mémoire tampon et la mémoire de masse est invariable, cela revient à dire que le rythme d'acquisition des images peut être doublé.

Une façon connue de comprimer une succession d'informations numériques résulte de la constatation que deux pixels voisins sont rarement très différents. Par conséquent, il est avantageux de mémoriser, non pas les pixels $X_i$, mais les différences $X_i-X_{i-1}$. En effet, si les pixels $X_i$ sont codés sur 8 bits, soit 256 valeurs possibles, la différence de deux pixels voisins sera dans la grande majorité des cas codable sur un nombre de bits inférieur à 5.

On connaît d'après le document "Nachrichtentechnische Zeitschrift, volume 27, N°3, Mars 1974, pages 115-118", un procédé de compression d'informations par suppression du bit de signe, mais ce procédé se fait avec perte d'informations et avec un code de longueur fixe.

Cependant, si on s'impose un codage sans perte d'information, il faut pouvoir aussi mémoriser les différences importantes entre pixels voisins, dont la probabilité d'apparition est faible mais qui se produisent néanmoins pour des détails aux transitions très contrastées. Pour résoudre ce problème, on a déjà proposé des codes à longueur variable, par exemple les codes de Huffman. Un tel code se traduit par un tableau de conversion où chaque valeur possible de différence (entre -255 et +255 pour l'exemple évoqué ci-dessus) reçoit un code binaire de longueur inversement proportionnelle à sa fréquence d'apparition. Ainsi, les valeurs de différence qui apparaissent le plus souvent au codage pendant l'exploration de l'image, pixel par pixel, reçoivent les codes les plus courts.

L'invention vise plusieurs perfectionnements de ce type de codage.

En premier lieu, l'invention concerne donc un procédé de compression d'une succession d'informations numériques binaires sous perte d'informations se présentant sous la forme de mots de format fixe représentant des nombres entiers positifs de l'intervalle [0,N] consistant à soustraire chaque mot du précédent de façon à obtenir chaque fois une différence de format variable comportant un bit de signe, caractérisé en ce qu'il consiste, pour au moins certaines valeurs absolues de différences, à supprimer ledit bit de signe de ladite différence:
- si la valeur absolue de celle-ci est supérieure à la valeur du mot précédent lorsque celui-ci est compris dans la première moitié dudit intervalle, ou,
- si la valeur absolue de ladite différence est supérieure à la valeur de la différence entre le nombre N et la valeur du mot précédent lorsque celui-ci est compris dans la seconde moitié dudit intervalle, et
- à transférer les informations ainsi comprimées, par exemple vers une mémoire.

Une autre caractéristique importante de l'invention consiste à coder directement la valeur du pixel dès que la différence dépasse, en valeur absolue, un nombre choisi. En effet, si on considère des pixels codés sur 8 bits, par exemple, une valeur de différence importante nécessite 9 bits pour être codée, en raison du signe de cette différence. Il devient alors avantageux de coder directement le pixel sur 8 bits, puisque c'est obligatoirement un nombre positif. Dans l'exemple qui sera décrit plus loin, on code directement le pixel (sur 8 bits) dès que la différence dépasse 31 en valeur absolue.

Enfin, une autre particularité notable de l'invention consiste à définir des intervalles donnés de différences possibles et à identifier chaque intervalle par un préfixe donné. Un suffixe comportant un nombre de bits suffisant pour représenter toutes les valeurs absolues de différences possibles dans l'intervalle considéré, suit directement le préfixe et un bit supplémentaire indique le signe. Ce mode d'identification des valeurs de différence a l'avantage de réduire "l'arborescence" des circuits électroniques de décodage, c'est-à-dire le nombre de tests logiques à effectuer avant de reconnaître complètement un mot. Ainsi, par exemple, la reconnaissance du préfixe pourra être exploitée pour adresser une table (mémoire morte) contenant directement toutes les valeurs possibles de différences dans l'intervalle correspondant au préfixe.

L'invention concerne aussi un dispositif de compression d'une succession d'informations numeriques binaires sous perte d'informations se presentant sous forme de mots de format fixe représentant des nombres entiers positifs de l'intervalle [0,N] comportant une entrée de mot où sont appliqués lesdits mots, un registre formant mémoire relié à ladite entrée pour mémoriser à chaque instant la valeur du mot précédant celui qui est appliqué à ladite entrée, et une mémoire pour recevoir une succession d'informations numériques de longueurs variables représentatives de la succession desdits mots de format fixe, caractérisé en ce qu'il comporte:

des moyens pour transférer vers ladite mémoire tampon

- soit la valeur absolue de la différence entre le mot appliqué à ladite entrée et ledit mot précédent si la valeur absolue de ladite différence est supérieure à la valeur du mot précédent lorsque celui-ci est compris dans la première moitié dudit intervalle ou si la valeur absolue de ladite différence est supérieure à la valeur de la différence entre le nombre N et la valeur du mot précédent lorsque celui-ci est compris dans la seconde moitié dudit intervalle,

- soit la valeur de cette différence et de son signe dans le cas contraire.

L'invention sera mieux comprise et d'autres avantages de celle-ci apparaîtront mieux à la lumière de la description qui va suivre d'un mode de réalisation particulier d'un dispositif de compression conforme à son principe, donnée uniquement à titre d'exemple et faite en référence aux dessins annexés dans lesquels:

- la figure 1 est un schéma bloc d'un dispositif de compression conforme à l'invention;
- la figure 2 est un schéma de principe d'un séquenceur du dispositif de la figure 1;
- la figure 3 est un schéma de principe d'un circuit de traitement de la figure 1 pour le codage des informations; et
- la figure 4 illustre le principe du décodage.

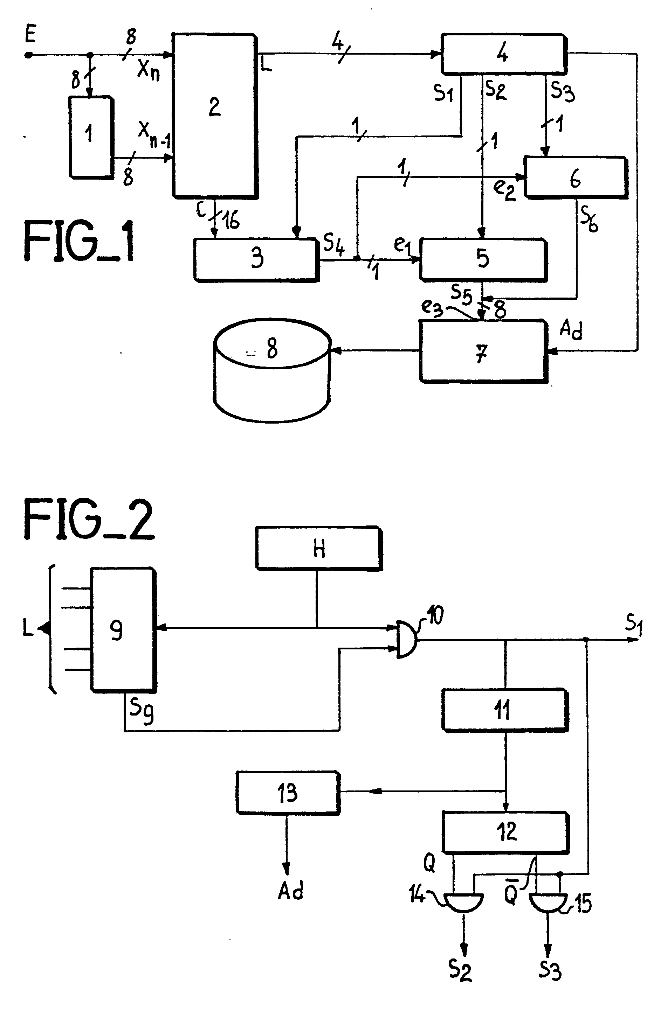

La figure 1 représente le schéma bloc d'un circuit de compression d'une succession de mots représentant les pixels d'une image. Les mots de 8 bits se présentent sous forme parallèle et sont appliqués à une entrée E pour subir une compression tandis que les informations numériques résultant de cette compression sont inscrits en série dans une mémoire tampon 7. Cette dernière est couplée à une mémoire de masse 8 (système à disque magnétique par exemple) et des lectures répétées de la mémoire tampon permettent "d'alimenter" la mémoire de masse B. Le but de la compression est d'augmenter la cadence d'acquisition des images malgré un rythme de transfert relativement lent entre les mémoires 7 et 8.

Comme mentionné précédemment, le procédé de compression consiste pour l'essentiel à mémoriser, non les mots de 8 bits représentant les pixels mais la différence entre deux pixels successifs, en utilisant un code de longueur variable. L'entrée E est donc reliée à une entrée $X_n$ d'un circuit de traitement 2 qui sera décrit plus loin et à un registre 1 formant mémoire dont la sortie est reliée à une entrée $X_{n-1}$ du circuit de traitement 2. Ce dernier reçoit donc à tout moment sur ses deux entrées la valeur d'un pixel et celle du pixel précédent. Les entrées E, $X_n$, $X_{n-1}$ sont des entrées parallèles de 8 bits (c'est-à-dire présentant chacune 8 bornes d'accès) et le registre 1 est à entrée parallèle et sortie parallèle, également sur 8 bits. Sur les dessins, chaque liaison parallèle est conventionnellement représentée par un seul fil coupé par un trait oblique auprès duquel figure le nombre de bits de ladite liaison. Le circuit 2 comporte une sortie parallèle C (de 16 bits) délivrant l'information (le code) à enregistrer, codée et "formatée", ainsi qu'une sortie parallèle L (de 4 bits) délivrant une information représentative de la longueur du code apparaissant simultanément à la sortie C. La sortie L est appliquée à une entrée d'un séquenceur 4 comportant 3 sorties d'horloge S1, S2 et S3 connectées respectivement pour piloter trois registres de 8 bits, 3, 5 et 6. L'agencement du séquenceur 4 sera décrit plus loin. La sortie C du circuit de traitement 2 est reliée à l'entrée du registre 3 qui est du type à chargement parallèle et sortie série. Le séquenceur décode la longueur utile du code C "formatée" à 16 bits, à transférer en série vers le registre 5 ou le registre 6. Plus précisément, la sortie S1 délivre chaque fois un nombre d'impulsions égal à la longueur L et ce signal d'horloge appliqué au registre 3 pilote le transfert des bits de poids fort correspondants vers le registre 5 ou 6 qui se trouve validé par l'horloge S2 ou S3 correspondante.

Par exemple, si le mot représentatif d'une différence $X_n$-$X_{n-1}$ est égal à +2, ce qui peut se transcrire en code comprimé binaire:

1100 avec L = 4

le code C "formaté" à 16 bits sera

0000000000001100

Mais la sortie L programme le séquenceur pour que celui-ci ne génère que 4 impulsions d'horloge à la sortie S1 de sorte que seul le mot 1100 s'inscrit dans l'un des registres 5 ou 6. Le format adopté de 16 bits, pour le code C correspond à la longueur maximum des mots à transférer dans la mémoire 7.

La sortie série S4 du registre 3 est reliée aux entrées $E_1$ et $E_2$ des registres 5 et 6, respectivement. Ces registres sont du type entrée série - sortie parallèle. Les deux sorties $S_5$, $S_6$ de ces registres sont reliées à une entree parallèle $E_3$ de la mémoire 7 qui comporte en outre une entrée d'adressage Ad pilotée par le séquenceur 4. La présence des deux registres 5 et 6 se justifie par le fait que la mémoire 7 est classiquement agencée en mots adressables de 8 bits. Ainsi, les horloges disponibles aux sorties 52 et 53 valident alternativement les registres 5 et 6. Chaque fois qu'un registre 5 (ou 6) a reçu 8 bits en provenance du registre

0 142 439

3, le séquenceur commute la suite du déchargement du registre 3 vers l'autre registre 6 (ou 5). Dans le même temps il génère l'adresse de la mémoire 7 à laquelle doit être déchargé le registre 5 (ou 6).

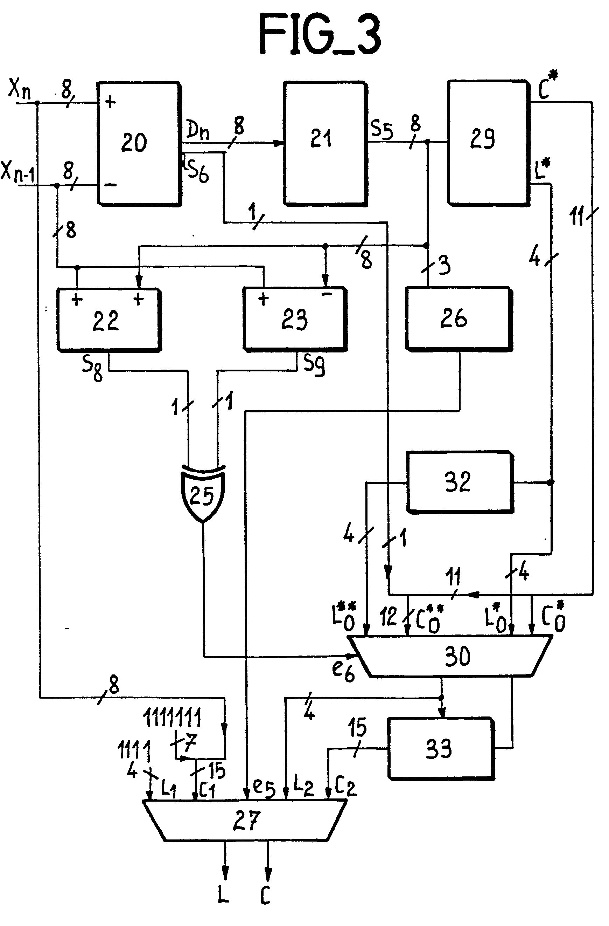

Le séquenceur est représenté à la figure 2. Il comporte un générateur d'horloge H qui pilote un décompteur 9 à entrée de consigne parallèle, connectée à la sortie L du circuit 2 et recevant par conséquent un mot représentatif de la longueur du code. Le générateur d'horloge N est également relie a une entrée d'une porte ET, 10 à deux entrées dont la sortie constitue la sortie S1 pilotant le registre 3. Le décompteur 9 comporte une sortie $S_9$ dite "d'état zéro" qui change d'état lorsque l'horloge H a remis le décompteur à zéro, c'est-à-dire lorsqu'elle a délivré un nombre d'impulsions correspondant à la longueur L affichée à l'entrée de consigne. Cette sortie $S_9$ est connectée à l'autre entrée de la porte 10. Son changement d'état bloque la porte 10 et interrompt donc la transmission des impulsions d'horloge à la sortie $S_1$. La sortie de la porte ET, 10 est aussi reliée à l'entrée d'un compteur II. Il s'agit d'un compteur par huit qui pilote une bascule bistable 12 et un compteur d'adresses 13. La sortie de ce dernier constitue la sortie Ad qui pilote la mémoire 7. La sortie Q de la bascule 12 est reliée à une entrée d'une porte ET, 14, à deux entrées tandis que sa sortie Q est reliée à une entrée d'une porte ET, 15, à deux entrées. Les deux autres entrées des portes 14 et 15 sont connectées à la sortie $S_1$. Les sorties des portes 14 et 15 constituent les sorties $S_2$ et $S_3$ mentionnées ci-dessus. Ainsi, chaque fois que le compteur 11 a enregistré 8 impulsions d'horloge H transmises par la porte 10, il pilote le changement d'état de la bascule 12, ce qui inverse la validation des registres 5 et 6 pour le chargement des informations délivrées par le compteur 3. Dans le même temps, le compteur 11 incrémente le compteur d'adresses 13 d'une unité, pour le transfert des informations contenues dans le registre qui vient d'être "rempli" à une nouvelle adresse de la mémoire 7.

Avant d'aborder la description du circuit de traitement 2 qui effectue l'essentiel des opérations de compression des informations représentatives des pixels $X_i$, il faut expliciter le processus de codage choisi.

Soit $D_n$, la différence entre deux pixels consécutifs:

$$D_n = X_n - X_{n-1}$$

comme $X_n$ et $X_{n-1}$ sont des nombres entiers compris dans un intervalle positif donné [0 à 255], $D_n$ est compris dans l'intervalle [-255 +255]. A titre d'exemple non limitatif, la conversion des valeurs $D_n$ possibles en code binaire peut être conforme au tableau suivant:

| Difféfence | Code (C) | Longueur (L) |
| --- | --- | --- |
| 0 | 0 | 1 |
| ± 1 | 10S | 3 |
| ± 2 | 110S | 4 |
| ± 3 | 11100S | 6 |
| ± 4 | 11101S | 6 |
| ± 5 | 111100S | 7 |
| ± 6 | 1111010S | 8 |
| ± 8 à ± 15 | 111110XYZS | 10 |
| ± 16 à ± 31 | 1111110XYZTS | 12 |
| ± 32 à ± 255 | 1111111ABCDEFGH | 15 |

On vérifie que $D_n = 0$, c'est-à-dire la valeur de différence statistiquement la plus fréquente dans la succession des pixels de l'image, est codée avec le mot de longueur minimum, c'est-à-dire sur un bit. Les autres valeurs de différences assez probables, comme par exemple ± 1, ± 2, ne nécessitent que trois ou quatre bits. Les valeurs de différences plus importantes (comme par exemple l'intervalle ± 16 à ± 31) nécessitent jusqu'à 12 bits mais leur probabilité d'apparition est très faible de sorte que cela joue peu sur le taux de compression obtenu. Dans le code, le dernier bit 5 représente le signe. Par exemple, S = 0 si la différence $D_n$ est positive et S = 1 si $D_n$ est négative. Comme on le verra plus loin, le bit de signe peut dans certains cas être supprimé.

Par ailleurs, selon un aspect avantageux de l'invention et à partir d'une valeur absolue de différence supérieure à 7, les mots de code sont agencés avec un préfixe d'identification et un suffixe ainsi que (éventuellement) le bit de signe S. Le préfixe d'identification désigne un intervalle donné de valeurs absolues de différences. Par exemple, pour l'intervalle double de différences [± 8 à ± 15] on définit un premier préfixe 111110, pour l'intervalle double de différences [± 16 à ± 31], on définit un second préfixe 1111110, et pour l'intervalle double de différences [± 32 à ± 255] on définit un troisième préfixe 1111111. On notera que le suffixe XYZ comporte un nombre de bits suffisant (trois) pour représenter toutes les valeurs absolues de différences possibles dans l'intervalle [± 8 à ± 15], puisque 3 bits permettent 8 combinaisons binaires. Il en est de même pour l'intervalle [± 16 à ± 31], dont le suffixe comporte 4 bits : XYZT.

En revanche, selon une particularité avantageuse de l'invention, on transfère directement le mot de format fixe représentant le pixel vers la mémoire tampon 7 lorsque la valeur absolue de la différence entre ce mot et le précédent dépasse un nombre choisi. Selon l'exemple, ce nombre choisi est 31 de sorte que pour l'intervalle double de différences [± 32 à ± 255], le suffixe ABCDEFGH représente la valeur même du pixel. En effet, au-delà de 31, le codage de la différence nécessiterait plus de bits, compte tenu de la nécessité de coder le signe S, que le codage du pixel lui-même (toujours positif). On associe à ce suffixe, un troisième préfixe

4

**0 142 439**

d'identification, à savoir 1111111.

Selon une caractéristique importante de l'invention, le bit de signe S est supprimé au codage chaque fois que c'est possible. Il est à noter que les conditions de suppression du bit de signe S, telles qu'elles vont être exposées ci-dessous, peuvent s'appliquer en théorie sur tout l'intervalle des valeurs de différences possibles (c'est-à-dire [-255 à +255] dans le cas décrit) mais que, en raison de la particularité de codage direct du pixel dans l'intervalle double [$\pm$32 à $\pm$255], ces conditions n'ont de sens que pour l'intervalle complémentaire [-31 à +31] non compris le zéro. Les exemples qui suivent permettent de comprendre les conditions de suppression du bit de signe S.

On a toujours $0 \leqslant X_i \leqslant N$, selon l'exemple $0 \leqslant X_i \leqslant 255$

a) supposons $X_{n-1} = 0$, quelle que soit la valeur du pixel suivant $X_n$, la différence: $D_n = X_n\text{-}X_{n-1}$ est forcément positive. On peut donc supprimer le signe S de $D_n$ dans tous les cas.

b) supposons $X_{n-1} = 1$, la seule différence négative possible est -1, il faut alors coder $\pm$1 sur 3 bits en conservant le bit de signe. Pour toutes les autres valeurs de différences, $D_n$ peut être amputé du bit de signe S.

c) supposons $X_{n-1} = 2$, les seules différences négatives possibles sont -1 et -2. Pour lever l'indétermination, il faut donc coder $\pm$1 et $\pm$2 en conservant le bit de signe S. Pour toutes les autres valeurs de différences $D_n$ peut être amputé du bit de signe S.

On peut continuer ce raisonnement pour toutes les valeurs de l'avant dernier pixel $X_{n-1}$, comprises dans la première moitié de l'intervalle de variation des pixels $X_i$. Autrement dit, on supprime le bit de signe S si la valeur absolue de la différence $D_n$ est supérieure à l'avant dernier mot lorsque celui-ci est compris dans la première moitié de l'intervalle des $X_i$. En fait, pour la raison indiquée précédemment, ce genre de test sera arrêté lorsque la valeur absolue de la différence sera supérieure à 31.

d) supposons maintenant $X_{n-1} = N = 255$. Quelle que soit la valeur du pixel suivant $X_n$, la différence $D_n = X_n\text{-}X_{n-1}$ est forcément négative. On peut donc aussi supprimer le signe S de $D_n$ dans tous les cas.

e) supposons $X_{n-1} = 254$, la seule différence positive possible est $+ 1$ si $X_n = 255$. Pour lever l'indétermination on code les différences $D_n = \pm 1$ sur 3 bits en conservant le bit de signe. Pour toutes les autres valeurs de différences, $D_n$ peut être amputé du bit de signe S.

f) supposons $X_{n-1} = 253$, les seules différences positives possibles sont $+1$ et $+2$, correspondant à $X_n = 254$ ou $X_n = 255$. On code alors les différences $\pm 1$ et $\pm 2$ en conservant le bit de signe S. Pour toutes les autres valeurs de différences, $D_n$ peut être amputé du bit de signe S.

On peut continuer ce raisonnement pour toutes les valeurs de l'avant dernier pixel $X_{n-1}$ comprises dans la seconde moitié de l'intervalle de variation des pixels $X_i$. Autrement dit, on supprime le bit de signe S si la valeur absolue de la différence $D_n$ est supérieure à la valeur de la différence entre le nombre N ($N = 255$) et la valeur de l'avant dernier pixel $X_{n-1}$, lorsque celui-ci est compris dans la seconde moitié de l'intervalle de variation des pixels $X_i$. Là encore, cependant, ce genre de test est abandonné lorsque la valeur absolue de la différence devient supérieure à 31.

On va maintenant décrire en référence à la figure 3 un mode de réalisation possible du circuit de traitement 2. Les entrées $X_n$ et $X_{n-1}$ sont directement reliées aux entrées d'un soustracteur numérique 20 dont la sortie parallèle $D_n$ (sur 9 bits) délivre à chaque instant la valeur de la différence:

$$D_n = X_n \text{ - } X_{n-1}$$

On peut par exemple utiliser un circuit intégré du commerce de type ALU 4 bits (TTL 181) proposé par les principaux constructeurs de semi-conducteurs. Comme la représentation binaire utilisée dans le soustracteur est une représentation en complément à deux, on utilise une mémoire morte 21 (PROM) pour extraire la valeur absolue de la différence. La valeur absolue apparaît codée sur 8 bits, à une sortie $S_5$ parallèle de la mémoire 21 et le bit de signe apparaît à une sortie $S_6$ du soustracteur 20. La mémoire morte 21 est adressée directement par la sortie $D_n$, c'est-à-dire que la sortie parallèle $D_n$ du soustracteur 20 est reliée à une entrée d'adressage de la mémoire morte, chaque valeur de $D_n$ constituant une adresse de la mémoire 21 où se trouve inscrite la valeur absolue correspondante. La capacité de la mémoire 21 est réduite puisqu'elle doit contenir 512 mots de 8 bits. On peut par exemple utiliser un circuit intégré du type 82S115 proposé par les principaux constructeurs de semi-conducteurs; un seul boîtier suffit pour réaliser la mémoire 21. La programmation de cette dernière est à la portée de l'homme du métier.

La sortie $S_5$ et l'entrée $X_{n-1}$ sont également rellées aux deux entrées (de type parallele, 8 bits) d'un additionneur numérique 22 et aux deux entrées d'un soustracteur numérique 23, de façon à réaliser les deux opérations suivantes:

$$X_{n-1} + |D_n|$$

$$X_{n-1} \text{ -} |D_n|$$

Les circuits 22 et 23 peuvent être réalisés à partir du même type de circuit intégré que le soustracteur 20. La sortie "report" $S_8$ de l'additionneur 22 et la sortie "report" $S_9$ du soustracteur 23 sont reliées respectivement aux deux entrées d'une porte 25 du type OU Exclusif. Autrement dit, la sortie $S_8$ affiche la valeur du bit de report de l'opération $X_{n-1} + |D_n|$ tandis que la sortie $S_9$ affiche la valeur du bit de report de l'opération $X_{n-1} \text{ -} |D_n|$. L'ensemble (22, 23, 25) qui vient d'être décrit réalise de façon simple l'ensemble des tests (définis ci-dessus)

5

permettant de déterminer si le bit de signe peut être supprimé ou non. On vérifie en effet que si les deux valeurs:

$X_{n-1} + |D_n|$ et $X_{n-1} - |D_n|$ sont dans l'intervalle [0,N], cela signifie qu'il faut tenir compte du signe dans la transmission du code C vers la mémoire tampon. Si au contraire une valeur se trouver à l'extérieur de l'intervalle [0,N], cela signifie qu'on peut supprimer le bit de signe. Or, ces conditions s'expriment par la table de la vérité de la porte 25, puisque, si la sortie de cette porte est à 1, cela signifie que l'un seulement des bits de report a la valeur 1, c'est-à-dire que le résultat de l'une seulement des opérations est en dehors de l'intervalle [0,N].

Par ailleurs, la sortie $S_5$ est reliée à un comparateur 26 qui permet de déterminer si la valeur absolue de la différence $D_n$ est supérieure ou inférieure à 31. Pratiquement, ce comparateur peut être une simple porte OU à trois entrées auxquelles on relie les trois dernières bornes de la sortie $S_5$ (sur lesquelles apparaissent les bits de poids fort). Comme le nombre 31 s'exprime par:

00011111 en binaire,

un nombre supérieur aura forcément au moins l'un de ses trois bits de poids forts égal à 1. La sortie de cette porte est reliée à une entrée de pilotage $e_5$ d'un multiplexeur 27 dont les sorties L et C sont les sorties représentées à la figure 2. Ce multiplexeur comporte deux groupes d'entrées $L_1$, $C_1$ et $L_2$, $C_2$, respectivement, et son rôle consiste simplement à faire correspondre les entrées $L_1$, $C_1$ ou $L_2$, $C_2$ avec les sorties L, C en fonction de la commande appliquée à l'entrée $e_5$. L'entrée $L_1$ est fixe et exprime le nombre 15 en binaire, les 8 bornes correspondant aux bits de poids faibles de l'entrée $C_1$ reçoivent directement le mot $X_n$ tandis que les 7 bornes correspondant aux bits de poids forts de cette même entrée $C_1$ sont toutes à 1. Ainsi se trouve simplement réalisée la double transcription Longueur, Code, dans le cas ou la valeur de la différence appartient à l'intervalle double [$\pm 32$ à $\pm 255$] identifié par le comparateur 26. Le multiplexeur 27 peut par exemple être réalisé à partir d'un circuit intégré du type 74244.

La sortie $S_5$ de la mémoire morte 21 est elle-même reliée à l'entrée d'adressage d'une mémoire morte 29 dans laquelle sont inscrites les 256 possibilités pour la longueur L et la valeur du code C, sans le signe S, notées respectivement $L^*$ et $C^*$ correspondant aux différentes valeurs possibles de la sortie $S_5$. Comme le code $C^*$ nécessite 11 bits et la longueur $L^*$ en nécessite 4, la mémoire morte 29 ne nécessitera que 3 boîtiers de type 82S115. Sa programmation d'adressage correspond au tableau de correspondance décrit ci-dessus, sauf en ce qui concerne l'intervalle double [$\pm 32$ à $\pm 255$] et le bit de signe S qui n'apparaît pas. Les sorties $C^*$ et $L^*$ sont reliées à des entrées correspondantes d'un multiplexeur 30 du même type que le multiplexeur 27. Les sorties du multiplexeur 30 sont reliées aux entrées $L_2$, $C_2$ du multiplexeur 27. Le rôle du multiplexeur 30 est donc de relier soit le groupe d'entrées $L_0^*$, $C_0^*$ soit le groupe d'entrées $L_0^{**}$, $C_0^{**}$ aux entrées correspondantes $L_2$, $C_2$. L'entrée de pilotage $e_6$ du multiplexeur 30 est reliée à la sortie de la porte 25 de type OU Exclusif. L'entrée $L_0^{**}$ est reliée à la sortie $L^*$ de la mémoire morte 29 par l'intermédiaire d'un opérateur binaire 32 qui réalise l'opération suivante:

$$L_0^{**} = L^* + 1$$

cette incrémentation permet donc de calculer la nouvelle longueur du code lorsqu'on réintroduit le signe S. L'entrée $C_0^{**}$ est reliée à la sortie $C^*$ de la mémoire 29 et comporte une borne supplémentaire reliée à la sortie $S_6$ du soustracteur 20. Le signal de pilotage appliqué à l'entrée $e_6$ permet donc de sélectionner les entrées $L_0^*$, $C_0^*$ lorsque le bit de signe S peut être supprimé ou les entrées $L_0^{**}$ $C_0^{**}$ lorsqu'il doit être conservé. On peut prévoir un registre 33 entre le multiplexeur 30 et l'entrée $C_2$ du multiplexeur 27 pour "formater" l'information de code à 15 bits, le registre étant piloté par l'information de longueur transmise simultanément à l'entrée $L_2$.

Le fonctionnement du circuit de traitement de la figure 3 résulte avec évidence de sa description. On voit que pour tout couple de pixels $X_n$, $X_{n-1}$, on effectue systématiquement la différence $D_n$ (soustracteur 20) puis on classe la valeur absolue de $D_n$ par rapport audit "nombre choisi", c'est-à-dire 31, grâce au comparateur 26. Cette classification permet de positionner le multiplexeur 27, c'est-à-dire de transmettre éventuellement le mot $X_n$ et sa longueur vers les sorties L et C du multiplexeur 27 si $|D_n| > 31$. Dans le cas contraire, on supprime le signe de la différence lorsque c'est possible, ce qui se traduit par le positionnement du multiplexeur 30 sous le contrôle de la porte 25. Si le signe peut être supprimé, les sorties $L^*$ $C^*$ de la mémoire 29 deviennent les sorties L, C du système. Dans le cas contraire, on les complète pour réintroduire le signe disponible à la sortie $S_6$.

Bien entendu, le circuit 2 qui vient d'être décrit, admet de nombreuses variantes. Parmi celles-ci, il est d'ores et déjà avantageux, compte tenu des capacités des mémoires mortes proposées dans le commerce, de remplacer l'ensemble de ce circuit par une unique mémoire morte (PROM) adressée directement par les valeurs $X_n$ et $X_{n-1}$. Autrement dit, en se reportant à nouveau à la figure 1, le bloc 2 peut être une simple mémoire morte. Si les entrées $X_n$ et $X_{n-1}$ sont codées chacune sur 8 bits, ce qui est assimilable à une entrée d'adressage parallèle de 16 bits pour la mémoire morte, on a donc 65536 combinaisons possibles ce qui se traduit par 64 K mots de 15 bits pour le code C et 64 K mots de 4 bits pour le code L. Si on utilise par exemple des circuits intégrés du type 27128, qui ont chacun une capacité mémoire de 16 K octets, il suffira de huit boîtiers pour enregistrer une fois pour toutes les 64 K valeurs possibles du code C et de quatre boîtiers pour enregistrer les 64 K valeurs possibles de la longueur L, soit un total de douze boîtiers seulement.

La programmation de cette mémoire morte est à la portée de l'homme du métier. On pourra par exemple simuler le système de la figure 3 sur ordinateur en générant successivement toutes les valeurs possibles pour $X_n$ et $X_{n-1}$. On peut aussi construire le système de la figure 3 pour l'utiliser en tant que programmateur des

**0 142 439**

boîtiers.

Par conséquent, l'invention vise aussi tout procédé de compression dans lequel les résultats du codage des mots L et C ne résultent que d'une simple opération de lecture dans une mémoire, dès lors que cette dernière a été programmée en mettant en oeuvre les opérations et tests définis ci-dessus.

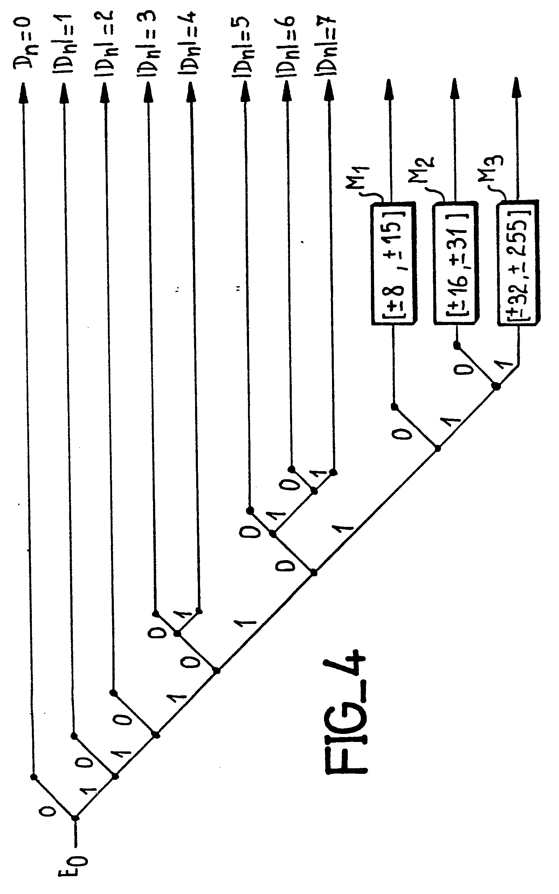

Le décodage va maintenant être brièvement explicité. Chaque point de "l'arborescence" de la figure 4 symbolise un test logique entre 0 et 1. La suite des bits représentant les informations après compression est appliquée à l'entrée $E_0$, le premier pixel ayant été codé en tant que tel. Par conséquent, si le bit suivant est zéro, on l'interprète comme $D_n = 0$. L'arrivée d'un 1 implique en revanche un test supplémentaire. Si le bit suivant est un zero, on aboutit à $|D_n| = 1$. Au contraire, si le bit suivant est encore 1 on progresse à nouveau dans l'arborescence pour pouvoir reconnaître $|D_n| = 2$ si le bit suivant est zéro et ainsi de suite.... Au delà de $|D_n| = 7$, l'arborescence est limitée grâce à l'emploi de tables (mémoires mortes) contenant toutes les combinaisons possibles des valeurs absolues de différences comprises dans les intervalles [8 à 15], [16 à 31] et [32 à 255]. Ainsi, la reconnaissance de cinq 1 consécutifs suivis d'un zéro provoque l'adressage de la mémoire $M_1$ (correspondant au premier intervalle) par les trois bits suivants. La reconnaissance de six 1 consécutifs suivis d'un zéro provoque l'adressage de la mémoire $M_2$ (correspondant au second intervalle) par les quatre bits suivants et la reconnaissance de sept 1 consécutifs provoque l'adressage de la mémoire $M_3$ (correspondant au troisième intervalle) par les huit bits suivants.

Un circuit mettant en oeuvre l'arborescence de la figure 3 est aisément réalisable à partir de bascules bistables et desdites mémoires mortes $M_1$, $M_2$ et $M_3$. On conçoit que la succession des bits à l'entrée $E_0$ conditionne ainsi la reconnaissance de la valeur absolue de la différence $|D_n|$.

Si on mémorise la valeur du pixel précédent, il est facile de refaire les opérations:

$$R + = X_{n-1} + |D_n|$$
$$R - = X_{n-1} - |D_n|$$

en s'inspirant de ce qui a été décrit en référence à la figure 3. Dès lors qu'on possède les résultats R + et R- de ces deux opérations, il suffit de vérifier si R + et/ou R- tombent dans l'intervalle [0,N]. Si une seule valeur est dans l'intervalle [0,N], il suffit de prendre cette valeur en tant que $X_n$. Si au contraire les deux valeurs R + et R- sont dans l'intervalle [0,N], il faut "appeler" le bit suivant qui se présente à l'entrée $E_0$ pour lever l'indétermination et compléter $|D_n|$ par son signe. La valeur même du signe S permet de choisir la valeur correcte de $X_n$ entre R + et R-. Si S = 0, cela implique que la différence $D_n$ est positive et la bonne valeur de $X_n$ est R +. Si S = 1, cela implique que la différence $D_n$ est négative et la bonne valeur de $X_n$ est R-.

**Revendications**

1. Procédé de compression d'une succession d'informations numériques binaires sans perte d'informations se présentant sous forme de mots de format fixe représentant des nombres entiers positifs de l'intervalle [0,N] consistant à soustraire chaque mot du précédent de façon à obtenir chaque fois une différence de format variable comportant un bit de signe, caractérisé en ce qu'il consiste, pour au moins certaines valeurs absolues de différences (21, $S_5$), à supprimer ledit bit de signe de ladite différence (29-L*,C*)
   - si la valeur absolue de celle-ci est supérieure à la valeur du mot précédent lorsque celui-ci est compris dans la première moitié dudit intervalle
   - ou si la valeur absolue de ladite différence est supérieure à la valeur de la différence entre le nombre N et la valeur du mot précédent lorsque celui-ci est compris dans la seconde moitié dudit intervalle (22, 23, 25)
   - et à transférer (27-L, C) les informations ainsi comprimées (3, 5, 6) vers une mémoire (7).

2. Procédé de compression selon la revendication 1, caractérisée en ce qu'il consiste à transférer directement le mot de format fixe ($X_n$) lorsque la valeur absolue de la différence entre ce mot et le précédent dépasse un nombre choisi (26, $E_5$).

3. Procédé de compression selon la revendication 1 ou 2 caractérisé en ce qu'il consiste, pour une partie desdites différences possibles, à coder celles-ci en mots comprenant:
   - un préfixe d'identification désignant un intervalle donné de valeurs absolues de telles différences
   - un suffixe comportant un nombre de bits suffisant pour représenter toutes les valeurs absolues de différences possibles dans cet intervalle donné, et
   - éventuellement un bit de signe.

4. Procédé selon la revendication 3 caractérisé en ce que les différences comprises entre -7 et +7, non compris une différence nulle, sont codées sur trois à huit bits dont un bit de signe, sans préfixe, une différence nulle étant codée sur un bit, en ce que les différences comprises entre 8 et 15 en valeur absolue sont codées sur quatre bits dont un bit de signe et associées à un premier préfixe et en ce que les différences comprises entre 16 et 31 en valeur absolue sont codées sur cinq bits dont un bit de signe et associées à un second préfixe.

5. Procédé selon l'ensemble des revendications 2 et 4, caractérisé en ce que, N étant égal à 255, chaque mot de format fixe pour lequel la valeur absolue de la différence entre ce mot et le précédent dépasse ledit nombre choisi est transmis tel quel et associé à un troisième préfixe, ledit nombre choisi étant égal à 31.

6. Procédé selon la revendication 5, caractérisé en ce que ledit premier pré fixe est 111110, en ce que ledit

7

second pré fixe est 1111110 et en ce que ledit troisième préfixe est 1111111.

7. Procédé selon l'une des revendications 2 à 6, caractérisé en ce qu'il consiste:
- à effectuer systématiquement la différence entre chaque mot de format fixe et le précédent (20),
- à classer la valeur absolue de cette différence (26) par rapport au nombre choisi précité, et
- à supprimer le signe de ladite différence (29) lorsque c'est possible si ladite valeur absolue de la différence est inférieure ou égale audit nombre choisi avant de transmettre ladite différence ou à transmettre directement ledit mot de format fixe si ladite valeur absolue de la différence est supérieure audit nombre choisi.

8. Procédé selon l'une des revendications précédentes, caractérisé en ce que les opérations élémentaires faites à partir de deux mots de format fixe consécutifs jusqu'au transfert de l'information correspondante après compression, consiste à lire une mémoire morte (2) dans laquelle tous les résultats possibles en fonction des valeurs des deux mots de format fixe ont été préalablement enregistrés.

9. Procédé selon la revendication 8 caractérisé en ce qu'on adresse ladite mémoire morte directement par les valeurs desdits mots de format fixe $(X_n, X_{n-1})$ consécutifs.

10. Procédé selon l'une des revendications 1 à 7, caractérisé en ce qu'on calcule la somme et la différence entre le mot précédent précité et la valeur absolue de la différence correspondante (22, 23) et en ce qu'on supprime ledit bit de signe si l'une seulement de ces deux valeurs calculées est comprise dans l'intervalle 0, N précité.

11. Dispositif de compression d'une succession d'informations numériques binaires sans perte d'informations se presentant sous forme de mots de format fixe représentant des nombres entiers positifs de l'intervalle [0, N] comportant une entrée de mot (E) où sont appliqués lesdits mots, un registre (1) formant mémoire relié à ladite entrée pour mémoriser à chaque instant la valeur du mot précédant celui qui est appliqué à ladite entrée, et une mémoire (7) pour recevoir une succession d'informations numériques de longueurs variables représentatives de la succession desdits mots de format fixe, caractérisé en ce qu'il comporte:
des moyens (2) pour transférer vers ladite mémoire tampon (7)
- soit la valeur absolue de la différence entre le mot appliqué à ladite entrée et ledit mot précèdent si la valeur absolue de ladite différence est supérieure à la valeur du mot précèdent lorsque celui-ci est compris dans la première moitié dudit intervalle ou si la valeur absolue de ladite différence est supérieure à la valeur de la différence entre le nombre N et la valeur du mot précèdent lorsque celui-ci est compris dans la seconde moitié dudit intervalle,
- soit la valeur de cette différence et de son signe dans le cas contraire.

12. Dispositif selon la revendication 11, caractérisé en ce que lesdits moyens comportent une mémoire morte (2) dans laquelle ont été préalablement inscrits les résultats d'un codage pour toutes les combinaisons possibles de valeurs d'un mot et d'un mot précédent, ladite entrée (E) et la sortie dudit registre (1) étant reliées aux moyens d'adressage de ladite mémoire morte (2).

13. Dispositif selon la revendication 11 caractérisé en ce que lesdits moyens comportent:
- un premier soustracteur numérique (20) dont les deux entrées sont respectivement reliées à ladite entrée de mot (E) et à la sortie dudit registre (1)
- un moyen pour extraire la valeur absolue (21) de la différence délivrée par ledit soustracteur,
- un additionneur numérique (22) et un second soustracteur numerique (23) dont deux entrées sont respectivement reliées à la sortie dudit registre (1) et à la sortie dudit moyen pour extraire la valeur absolue (21)
- une porte du type OU Exclusif (25) dont les deux entrées sont reliées respectivement aux sorties dudit soustracteur (22) et dudit second additionneur (23), et
- des moyens de transfert (30, 27) vers ladite mémoire (7), d'un code représentatif de ladite valeur absolue de la différence ou de la différence elle-même, sous la commande de ladite porte du type OU Exclusif.

14. Dispositif selon la revendication 13, caractérisé en ce que lesdits moyens de transfert comportent un multiplexeur (27) piloté par un comparateur (26) relié à la sortie dudit moyen pour extraire la valeur absolue de la différence, pour comparer cette valeur absolue à un nombre positif choisi, une entrée $(C_1)$ dudit multiplexeur étant reliée à l'entrée de mot précitée.

**Patentansprüche**

1. Verfahren zur Kompression einer Folge von digitalen Binärdaten ohne Informationenverlust, die sich in Form von Worten festen Formats darbieten, welche positive ganze Zahlen des Intervalls [0, N] darstellen bei welchem jedes Wort von dem vorausgehenden Wort subtrahiert wird, so daß jedes Mal eine veränderliche Formatdifferenz mit einem Vorzeichenbit erhalten wird, dadurch gekennzeichnet, daß es darin besteht, für wenigstens bestimmte Differenzabsolutwerte (21, $S_5$), das obengenannte Vorzeichenbit aus der obengenannten Differenz (29-L*, C*) zu unterdrücken; wenn der Absolutwert dieser Differenz größer ist als der Betrag des vorausgehenden Worts, wenn dieses in der ersten Hälfte des obengenannten Intervalls enthalten ist; oder wenn der Absolutwert der obengenannten Differenz größer ist als der Betrag der Differenz zwischen der Zahl H und dem Betrag des vorausgehenden Worts, wenn dieses in der zweiten Hälfte des obengenannten Intervalls (22, 23, 25) enthalten ist; und darin besteht, die derart komprimierten Informationen (3, 5, 6) einem

0 142 439

Speicher (7) zu überführen (27-L, C).

2. Verfahren zur Kompression nach Anspruch 1, dadurch gekennzeichnet, daß es darin besteht, das Wort festen Formats ($X_n$) unmittelbar zu überführen, wenn der Absolutwert der Differenz zwischen diesem und dem vorausgehenden dort eine ausgewählte Zahl (26, $E_5$) übersteigt.

3. Verfahren zur Kompression nach den Ansprüchen 1 oder 2, dadurch gekennzeichnet, daß es darin besteht, für einen Teil der obengenannten möglichen Differenzen sie in Worten zu kodieren, die enthalten: ein Identifikationspräfix, das ein vorgegebenes Intervall für die Absolutwerte solcher Differenzen kennzeichnet; ein Suffix mit einer ausreichender Bitzahl, um alle Absolutwerte der möglichen Differenzen in diesem vorgegebenen Intervall darzustellen, und eventuell ein Vorzeichenbit.

4. Verfahren nach Anspruch 3, dadurch gekennzeichnet, daß die zwischen -7 und +7 enthaltenen Differenzen, eine Nulldifferenz ausgeschlossen, auf drei bis acht Bits kodiert sind, wovon eine ein Vorzeichenbit ohne Präfix ist, wobei eine Nulldifferenz auf einem Bit kodiert ist, und daß die zwischen 8 und 16 im Absolutwert enthaltenen Differenzen auf vier Bits kodiert sind, wovon eines ein Vorzeichenbit ist, und einem ersten Prefix zugeordnet sind, und daß die zwischen 16 und 31 im Absolutwert enthaltenen Differenzen auf fünf Bits kodiert sind, wovon eines ein Vorzeichenbit ist, und einem zweiten Präfix zugeordnet sind.

5. Verfahren nach den gesamten Ansprüchen 2 und 4, dadurch gekennzeichnet, daß für N gleich 255, jedes Wort festen Formats, wofür der Absolutwert für die Differenz zwischen diesem und dem vorausgehenden Wort die ausgewählte Zahl übersteigt, als solches überführt und einem dritten Präfix zugeordnet wird, wobei die ausgewählte Zahl gleich 31 ist.

6. Verfahren nach Anspruch 5, dadurch gekennzeichnet, daß das obengenannte erste Präfix 111110 ist, daß das obengenannte zweite Präfix 1111110 ist und daß das obengenannte dritte Präfix 1111111 ist.

7. Verfahren nach einem der Ansprüche 2 bis 6, dadurch gekennzeichnet, daß es darin besteht: die Differenz zwischen jedem Wort festen Formats und dem vorausgehenden Wort (20) zu bilden; den Absolutwert dieser Differenz (26) bezüglich der obenerwähnten ausgewählten Zahl einzuordnen und, wenn möglich das Vorzeichen der obengenannten Differenz (29) zu beseitigen, wenn der obengenannte Absolutwert der Differenz kleiner ist als oder gleich ist wie die ausgewählte Zahl, bevor die obengenannte Differenz überführt wird, oder das obengenannte Wort festen Formats unmittelbar zu überführen, wenn der obengenannte Absolutwert für die Differenz größer ist als die ausgewählte Zahl.

8. Verfahren nach einem der vorstehenden Ansprüche, dadurch gekennzeichnet, daß die elementaren Operationen, die ab zwei auf einanderfolgenden Worten festen Formats ausgeführt sind bis zur Überführung der entsprechenden Information nach der Kompression ausgeführt werden, in dem Auslesen eines Festwertspeichers (2) bestehen, in welchem alle mögliche Ergebnisse in Abhängigkeit der Beträge der beiden Worte festen Formats vorher aufgenommen worden sind.

9. Verfahren nach Anspruch 8, dadurch gekennzeichnet, daß der obengenannte Festwertspeicher unmittelbar durch die Betrage der obengenannten aufeinanderfolgenden Worte festen Formats ($X_n$, $X_{n-1}$) adressiert wird.

10. Verfahren nach einem der Ansprüche 1 bis 7, dadurch gekennzeichnet, daß man die Summe und die Differenz zwischen den obengenannten vorausgehenden Wort und dem Absolutwert der entsprechenden Differenz (22, 23) berechnet und daß man das obengenannte Vorzeichenbit beseitigt, wenn nur einer dieser beiden berechneten Beträgen in dem obenerwähnten Intervall 0, N enthalten ist.

11. Vorrichtung zur Kompression einer Folge digitaler Binärinformationen ohne Informationsverlust, die als Wörter von festem Format erscheinen welche positive ganze Zahlen mit dem Intervall [0, N] darstellen, mit einem Worteingang (E) an den diese Wörter angelegt werden, einem Register (1) , das einen an diesen Eingang angeschlossenen Speicher bildet, um zu jedem Zeitpunkt den Wert des Wortes zu speichern, das demjenigen vorausgeht, das an diesen Eingang angelegt wird, und einem Speicher (7) zum Empfang einer Folge von Digitalinformationen variabler Länge, welche die genannte Folge von Wörtern festen Formats darstellen, dadurch gekennzeichnet, daß sie umfaßt:
Mittel (2), um zu dem genannten Pufferspeicher (7) zu übertragen: entweder den Absolutwert der Differenz zwischen dem an den genannten Eingang angelegten Wort und dem vorausgehenden Wort, denn der Absolutwert dieser Differenz größer als der Wert des vorausgehenden Wortes ist, wenn dieses in der ersten Hälfte des Intervalls liegt, oder wenn der Absolutwert dieser Differenz größer ist als der Wert der Differenz zwischen der Zahl N und dem Wert des vorausgehenden Wortes, wenn dieses in der zweiten Hälfte dieses Intervalls liegt; oder den Wert dieser Differenz und ihr Vorzeichen, wenn das Gegenteil zutrifft.

12. Vorrichtung nach Anspruch 11, dadurch gekennzeichnet, daß die genannten Mittel einen Festwertspeicher (2) enthalten, worin zuvor die Ergebnisse einer Kodierung für alle möglichen Kombinationen von Werten eines Wortes und eines vorausgehenden Wortes gespeichert wurden, wobei dieser Eingang (E) und der Ausgang des genannten Registers (1) mit den Mitteln zur Adressierung dieses Festwertspeichers (2) verbunden sind.

13. Vorrichtung nach Anspruch 11, dadurch gekennzeichnet daß diese Mittel umfassen: einen ersten digitalen Subtrahierer (20), dessen zwei Eingänge mit dem Worteingang (E) bzw. mit dem Ausgang des Registers (1) verbunden sind, einen Digitaladdierer (22) und einen zweiten digitalen Subtrahierer (23), dessen zwei Eingänge mit dem Ausgang dieses Registers (1) bzw. mit dem Ausgang der genannten Mittel (21) zum Entnehmen des Absolutwertes verbunden sind, eine Exklusiv-OR-Torschaltung (25), deren zwei Eingänge mit je einem Ausgang des Subtrahierers (22) und des zweiten Addierers (23) verbunden sind, und Mittel (30, 27), um zu dem Speicher (7) einen Kode zu überführen, der den Absolutwert der Differenz oder diese Differenz

9

**0 142 439**

darstellt, unter Steuerung durch diese Exklusiv-OR-Torschaltung.

14. Vorrichtung nach Anspruch 13, dadurch gekennzeichnet daß die Überführungsmittel einen Multiplexer (27) enthalten, der durch einen Komparator (26) gesteuert wird, der mit dem Ausgang der Mittel zum Entnehmen des Absolutwerts der Differenz verbunden ist. zum dergleichen dieses Absolutwerts mit einer gewählten positiven Zahl, wobei ein Eingang ($C_1$) des Multiplexers mit dem genannten Worteingang verbunden ist.

**Claims**

1. A method for the compression of succession of digital binary information without any loss of information in the form of words with a fixed format representing whole positive numbers with the interval [0, N] consisting of subtracting each word from the preceding one in such a manner as to obtain each time a variable format difference comprising a sign bit, characterized in that, it consists, for at least certain absolute values with differences (21, $S_5$), of suppressing the sign bit of the said difference (29-L*, C*)
- if the absolute value of the latter is greater than the value of the preceding word when the latter is comprised in the second half of the said interval,
- or if the absolute value of the said difference is greater than the value of the difference between the number N and the value of the preceding word if the latter is comprised in the second half of the said interval (22, 23, 25),
- and of transferring (27-L, C) the information compressed (3, 5, 6) in this manner into a memory (7).

2. The method of compression in accordance with claim 1, characterized in that it consists of directly transferring the word with a fixed format ($X_n$) when the absolute value of the difference between this word and the preceding one is in excess of a selected number (26, $E_5$).

3. The method of compression as claimed in claim 1 or claim 2, characterized in that it consists, in respect of a part of the said possible differences, of encoding the latter as words comprising:
- an identification prefix designating a given interval of the absolute values of such differences,
- a suffix comprising a number of bits sufficient to represent all the absolute values of the possible differences in this given interval, and possibly a sign bit.

4. The method as claimed in claim 3 characterized in that the differences comprised between -7 and +7 but not including a zero difference, are encoded as three to eight bits of which one is a sign bit, without a prefix, a zero difference being encoded as one bit, in that the differences comprised between 8 and 15 in an absolute value are encoded as four bits of which one is a sign bit and which are associated with a first prefix and in that the differences comprised between 16 and 31 as an absolute value are encoded as five bits of which one is a sign bit and which are associated with a second prefix.

5. The method as claimed in claims 2 and 4 taken together, characterized in that, N being equal to 255, each word with a fixed format in respect of which the absolute value of the difference between this word and the preceding one is in excess of the said selected number is transmitted as such and associated with a third prefix, said selected number being equal to 31.

6. The method as claimed in claim 5, characterized in that the said first prefix is 111110, in that the said second prefix is 1111110 and in that the said third prefix is 1111111.

7. The method as claimed in any one of the claims 2 through 6, characterized in that it consists of:
- systematically establishing the difference between each word with a fixed format and the preceding one (20),
- classifying the absolute value of this difference (26) in relation to the precited selected number, and
- of suppressing the sign of the said difference (29) if it is possible for the said absolute value of the difference to be less than or equal to the said selected number prior to transmission of said difference or of directly transmitting the said word with a fixed format if the said absolute value of the difference is in excess of the said selected number.

8. The method as claimed in any one of the preceding claims, characterized in that the elementary operations made starting with two consecutive words with a fixed format until the transfer of the corresponding information after compression consists of reading a ROM (2) in which all the possible results are stored as a function of the values of the two words with a fixed format.

9. The method as claimed in claim 8, characterized in that the said ROM is directly addressed using the values of the said consecutive words with a fixed format ($X_n$, $X_n$).

10. The method as claimed in any one of the claims 1 through 7, characterized in that the sum of the difference between the preceding precited word and the absolute value of the corresponding difference (22, 23) is computed and in that the said sign bit is suppressed if only one of these two computed values is comprised in the precited interval 0, N.

11. A device for the compression of a succession of binary digital information without any loss of information, presented in the form of words with a fixed format representing whole positive numbers with the interval [0, N], comprising a word input (E) for the said words, a register (1) forming a real memory at the said input for storing at each instant the value of the preceding word, same being applied to the said input, and a memory (7) for receiving a succession of digital information with variable lengths representing the succession

10

of the said words with a fixed format, characterized in that it comprises:

means (2) for transferring to the said buffer memory (7)

- either the absolute value of the difference between the word applied to the said input and the said preceding word if the absolute value of the said difference is greater than the value of the preceding word if the latter is comprised in the said first half of the said interval or if the absolute value of the said difference is greater than the value of the difference between the number N and the value of the preceding word if the latter is comprised in the second half of the said interval,

- or the value of this difference and its sign in the other case.

12. The device as claimed in claim 11, characterized in that the said means comprise a ROM (2) storing the results of encoding for all possible combinations of the values of a word and of a preceding word, the said input (E) and the said output of said register (1) being connected with addressing means of the said ROM (2).

13. The device as claimed in claim 11, characterized in that the said means comprise:

- a first digital subtracter (20) whose two inputs are respectively connected between the said word input (E) and the output of said register (1),

- means for extracting the absolute value (21) of the difference furnished by the said subtracter,

- a digital adder (22) and a second digital subtracter (23) whose inputs are respectively connected with the output of the said register (1) and the output of the said means for extracting the absolute value (21),

- a gate (25) of the OR exclusive type whose two inputs are respectively connected with the outputs of the said subtracter (22) and of the said second adder (23), and

- transfer means (30, 27) for transfer to the said memory (7) of a code representing the said absolute value of the difference or of the difference itself, under the control of said gate of the OR exclusive type.

14. The device as claimed in claim 13, characterized in that the said transfer means comprise a multiplexer (27) controlled by a comparator (26) connected with the output of the said means in order to extract the absolute value of the difference, to compare this absolute value with a positive selected number, an input ($C_1$) of the said multiplexer being connected with the input of the precited word.

FIG_1

FIG_2

# FIG_3

FIG_4